# EUROPEAN PATENT APPLICATION

(11) **EP 3 165 634 A1**
(43) Date of publication of application: **10.05.2017**
(21) Application number: 15814062.4
(22) Date of filing: 01.07.2015
(51) Int. Cl.: C30B 29/16, C30B 15/34

(54) **GALLIUM OXIDE SUBSTRATE**

(30) Priority: 02.07.2014 JP 2014137223
(71) Applicant: Tamura Corporation, Tokyo 178-8511 (JP); Koha Co., Ltd., Tokyo 178-8511 (JP)
(72) Inventor: KOSHI, Kimiyoshi, Tokyo 178-8511 (JP); WATANABE, Shinya, Tokyo 178-8511 (JP); YAMAOKA, Yu, Tokyo 178-8511 (JP); WATANABE, Makoto, Tokyo 178-8511 (JP)
(74) Representative: Betten & Resch
(86) International application number: PCT/JP2015/069015
(87) International publication number: WO 2016/002845

(57) **Abstract**

Provided is a gallium oxide substrate which has less linear pits. Obtained is a gallium oxide substrate wherein the average density of linear pits in a single crystal surface is 1,000 pits/cm2 or less.

## Description

### [Technical Field]

The invention relates to a gallium oxide substrate.

### [Background Art]

One of crystal growth methods used for producing a gallium oxide single crystal is the EFG (Edge-defined Film-fed Growth) method (see, e.g., PTL **1**).

When the gallium oxide single crystal is produced by using the EFG method described in PTL **1,** the gallium oxide single crystal is grown from gallium oxide melt.

### [Citation List]

### [Patent Literature]

[PTL **1**] JP-A-**2013-237591**

### [Summary of Invention]

### [Technical Problem]

In growing the gallium oxide single crystal, oxygen is supplied onto the surface of the gallium oxide melt to prevent the evaporation of the gallium oxide melt during the crystal growth. The present inventors, however, found that if oxygen is excessively supplied onto the surface of the gallium oxide melt, a lot of linear pits are occurred on the surface of the gallium oxide single crystal at the time of processing the grown gallium oxide single crystal into a substrate.

It is an object of an invention to provide a gallium oxide substrate that has a reduced number of linear pits.

### [Solution to Problem]

The above object will be attained by the respective inventions defined by [1] to [3] below.
[1] A gallium oxide substrate, wherein an average value of a density of linear pits is not more than **1000** pits/cm² in a surface of a single crystal.
[2] The gallium oxide substrate defined by [1], wherein an effective carrier concentration in the single crystal is in a range of **1x10¹⁷** [/cm**³**] to **1x10²⁰** [/cm**³**].
[3] The gallium oxide substrate defined by [1], wherein an effective carrier concentration in the single crystal is in a range of **2**.**05x10¹⁷** [/cm**³**] to **2.23x10¹⁹** [/cm**³**].

### [Advantageous Effects of Invention]

According to the invention, a gallium oxide substrate that has a reduced number of linear pits can be provided.

### [Brief Description of Drawings]

**[****FIG.1****]**

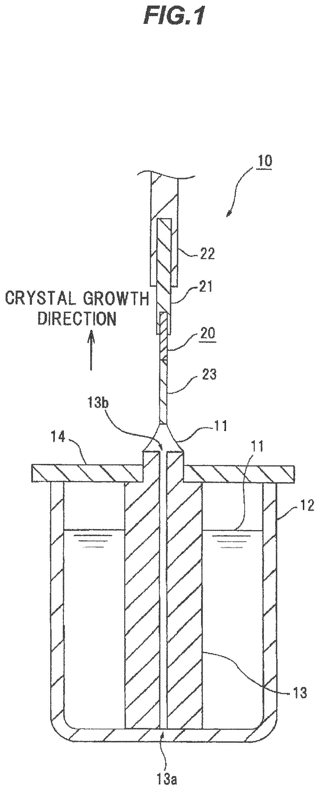

   **FIG.1** is a cross sectional view showing a main part of an EFG crystal manufacturing apparatus.
**[****FIG.2****]**

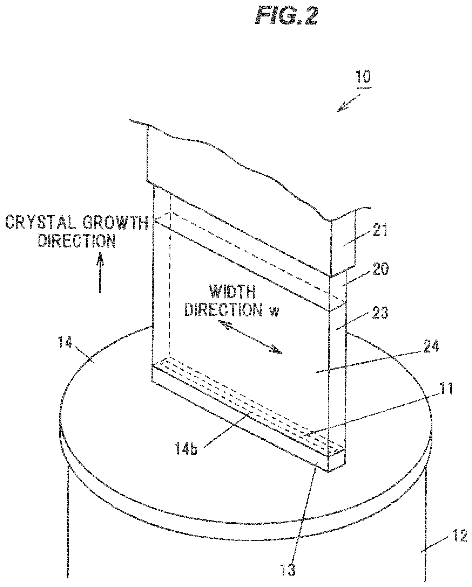

   **FIG.2** is a perspective view showing a state of a main part during growth of a β-Ga₂O₃-based single crystal.
**[****FIG.3****]**

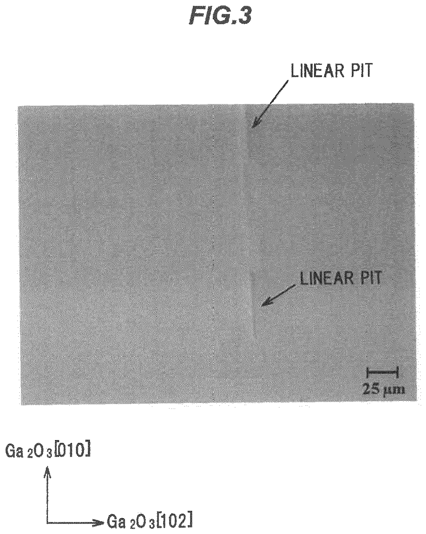

   **FIG.3** is an optical micrograph showing the surface state of a gallium oxide substrate polished by CMP.
**[****FIG.4****]**

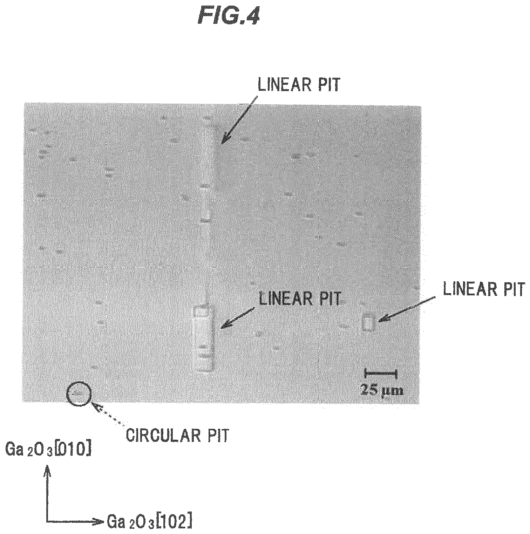

   **FIG.4** is an optical micrograph showing the surface state of the gallium oxide substrate etched with phosphoric acid.
**[****FIG.5****]**

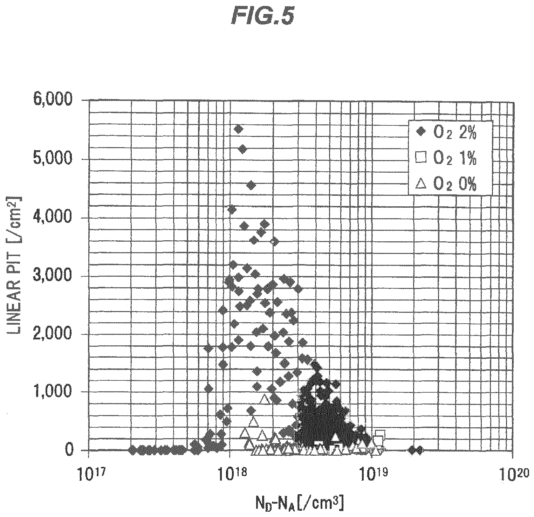

   **FIG.5** is a graph showing a relation between an effective carrier concentration in the β-Ga**₂**O**₃**-based single crystal and the number of linear pits on the β-Ga**₂**O**₃**-based single crystal per unit area.

### [Description of Embodiments]

Preferred embodiments of the invention will be specifically described below in conjunction with the appended drawings.

**FIGS.1** and **2** schematically shows an EFG crystal manufacturing apparatus generally denoted by the reference numeral **10.**

The EFG crystal manufacturing apparatus **10** is provided with a crucible **12** containing Ga₂O₃-based melt **11** obtained by melting Ga₂O₃-based powder, a die **13** placed in the crucible **12,** a lid **14** covering the upper surface of the crucible **12** except an opening **13**b of a slit **13**a, a seed crystal holder **21** for holding a β-Ga**₂**O**₃**-based seed crystal (hereinafter, referred as "seed crystal") **20,** and a shaft **22** vertically movably supporting the seed crystal holder **21.**

The crucible **12** is formed of a heat-resistant metal material such as iridium capable of containing the Ga**₂**O**₃**-based melt **11.** The die **13** has the slit **13**a to draw up the Ga₂O₃-based melt **11** by capillary action. The lid **14** prevents the high-temperature Ga₂O₃-based melt **11** from evaporating from the crucible **12** and also prevents the vapor of the Ga**₂**O**₃**-based melt **11** from attaching to a portion other than the upper surface of the slit **13**a.

The seed crystal **20** is moved down and is brought into contact with the Ga₂O₃-based melt **11** drawn up to the opening **13**b through the slit **13**a of the die **13** by capillary action, and the seed crystal **20** in contact with the Ga**₂**O**₃**-based melt **11** is pulled up, thereby growing a β-Ga**₂**O**₃**-based single crystal **23** into a plate shape. The crystal orientation of the β-Ga**₂**O**₃**-based single crystal **23** is the same as the crystal orientation of the seed crystal **20.** To control the crystal orientation of the β-Ga**₂**O**₃**-based single crystal **23,** for example, a plane orientation and an angle in a horizontal plane of the bottom surface of the seed crystal **20** are adjusted.

A surface **24** is a principal surface of the β-Ga₂O₃-based single crystal **23** which is parallel to a slit direction of the slit **13**a. When a β-Ga₂O₃-based substrate is formed by cutting the grown β-Ga**₂**O**₃**-based single crystal **23,** the plane orientation of the surface **24** of the β-Ga**₂**O**₃**-based single crystal **23** is made to coincide with the plane orientation of the principal surface of the β-Ga**₂**O**₃**-based substrate. For example, when forming a β-Ga**₂**O**₃**-based substrate of which principal surface is, e.g., a **(-201)** plane, the plane orientation of the surface **24** is **(-201).**

The seed crystal **20** and the β-Ga**₂**O**₃**-based single crystal **23** are β-Ga**₂**O**₃** single crystals, or β-Ga**₂**O**₃** single crystals containing an element such as Cu, Ag, Zn, Cd, Al, In, Si, Ge or Sn.

The β-Ga**₂**O**₃**-based single crystal **23** is grown using a mixed gas of oxygen O**₂** and at least one type of inert gas such as nitrogen N**₂**, argon Ar or helium He. The atmosphere used for growth of the β-Ga**₂**O**₃**-based single crystal **23** is a mixture of nitrogen N**₂** and oxygen O**₂** in the present embodiment, but it is not particularly limited thereto.

Since the Ga**₂**O**₃**-based melt **11** evaporates during the growth of the β-Ga**₂**O**₃**-based single crystal **23,** it is preferable that a β-Ga**₂**O**₃** single crystal be formed under the condition of the gas with a required flow ratio of oxygen to the Ga**₂**O**₃**-based melt **11.** The upper limit of the flow ratio of oxygen O**₂** to nitrogen N**₂** is controlled to not more than **2**% in the present embodiment, but it is not particularly limited thereto.

A gallium oxide substrate is cut out from the β-Ga**₂**O**₃**-based single crystal **23** having an average linear pit density of not more than **1000** pits/cm**²**.

Pits are crystal defects which appear as recesses on a crystal surface. The linear pits mentioned above are linear pits having a length of about several µm to several hundred µm and extending in a **[010]** direction. The length, width, depth and shape, etc., thereof are not specifically limited but point pits are not regarded as the linear pits.

Based on the findings by the present inventors, the yield of devices can be increased when gallium oxide substrates having an average linear pit density of not more than **1000** pits/cm**²** are used to manufacture the devices. Thus, not more than **1000** pits/cm**²** of the average linear pit density can be an indicator for proving a high-quality gallium oxide substrate.

A linear pit density of the gallium oxide substrate which is cut out from the β-Ga**₂**O**₃**-based single crystal **23** is evaluated by, e.g., the following method.

To evaluate the linear pit density, a thin plate-shaped gallium oxide substrate is firstly cut out from the β-Ga**₂**O**₃**-based single crystal **23.** Next, a principal surface of the thin plate-shaped gallium oxide substrate is polished.

**FIG.3** is an optical micrograph showing the surface state of a gallium oxide substrate polished by CMP (chemical mechanical planarization). **FIG.4** is an optical micrograph showing the surface state of the gallium oxide substrate etched with phosphoric acid. In general, the substrate manufacturing process is completed with CMP. However, in the present embodiment, phosphoric acid etching is also performed for the purpose of evaluation to allow linear pits to be easily observed, and the linear pit density is checked by counting the number of pits per unit area.

**FIG.5** is a graph showing a relation between a difference between a donor concentration N_{D} and an acceptor concentration N_{A} (an effective carrier concentration N_{D}-N_{A}) in the β-Ga**₂**O**₃**-based single crystal **23** per unit cubic centimeter and the number of linear pits on the β-Ga**₂**O**₃**-based single crystal **23** per unit area. The effective carrier concentration was evaluated by C-V measurement. The measurement range of the effective carrier concentration is from **1x10¹⁷** to **1x10²⁰** [/cm**³**].

In **FIG.5****,** filled diamonds indicate the measured values when the flow ratio of oxygen O**₂** to nitrogen N**₂** is **2**%, open squares indicate the measured values when the flow ratio of oxygen O**₂** to nitrogen N**₂** is **1**%, and open triangles indicate the measured values when the flow ratio of oxygen O**₂** to nitrogen N**₂** is **0**%.

When the flow ratio of oxygen O**₂** to nitrogen N**₂** supplied during growth of the β-Ga**₂**O**₃**-based single crystal is reduced from **2**% to not more than **1**%, the average density of linear pits occurred on the surface of the gallium oxide substrate cut out from the β-Ga**₂**O**₃**-based single crystal **23** can be reduced to not more than **1000** pits/cm**²**.

When the flow ratio of oxygen O**₂** to nitrogen N**₂** is **2**%, the average density of linear pits occurred on the surface of the gallium oxide substrate varies depending on the level of the effective carrier concentration N_{D}-N_{A}, as obvious from **FIG.5**. On the other hand, when the flow ratio of oxygen O**₂** to nitrogen N**₂** is not more than **1**%, the linear pits can be reduced to not more than **1000** pits/cm**²** regardless of the level of the effective carrier concentration N_{D}-N_{A}.

Based on **Fig.5****,** a lower limit in the measurement range of the effective carrier concentration N_{D}-N_{A} is **2.05x10¹⁷** [/cm**³**] when the flow ratio of oxygen O**₂** to nitrogen N**₂** is **2**%.

When the flow ratio of oxygen O**₂** to nitrogen N**₂** is **2**%, the linear pit density of the β-Ga**₂**O**₃**-based single crystal **23** is zero even if the effective carrier concentration N_{D}-N_{A} is reduced to the range of **2.05x10¹⁷** to **5.96x10¹⁷** [/cm**³**], and it is derived therefrom that the linear pit density is zero even at the effective carrier concentration N_{D}-N_{A} of not more than **2.05x10¹⁷** [/cm**³**]. Thus, it is derived that the linear pit density is zero even when the effective carrier concentration is reduced to about **1x10¹⁷** [/cm³] which is the lower limit of the evaluation range.

On the other hand, an upper limit in the measurement range of the effective carrier concentration N_{D}-N_{A} is **2.23x10¹⁹** [/cm**³**] when the flow ratio of oxygen O**₂** to nitrogen N**₂** is **2**%, as shown in **FIG.5****.**

When the flow ratio of oxygen **O₂** to nitrogen N₂ is **2**%, the linear pit density of the β-Ga**₂**O**₃**-based single crystal **23** is zero even if the effective carrier concentration N_{D}-N_{A} is increased to the range of **1.17x10¹⁹** to **2.23x10¹⁹** [/cm**³**], and it is derived therefrom that the linear pit density is zero even at the effective carrier concentration N_{D}-N_{A} of not less than **2.23x10¹⁹** [/cm**³**]. Thus, it is derived that the linear pit density is zero even when the effective carrier concentration is increased to about **1x10²⁰** [/cm**³**] which is the upper limit of the evaluation range.

When the flow ratio of oxygen O**₂** to nitrogen N**₂** is **1**%, a lower limit in the measurement range of the effective carrier concentration N_{D}-N_{A} is **4.2x10¹⁸** [/cm**³**] and an upper limit in the measurement range of the effective carrier concentration N_{D}-N_{A} is **1.15x10¹⁹** [/cm**³**].

Thus, if the effective carrier concentration N_{D}-N_{A} is in the range of **4.2x10¹⁸** to **1.15x10¹⁹** [/cm**³**], the average density of linear pits on the β-Ga**₂**O**₃**-based single crystal **23** can be reduced to not more than **1000** pits/cm**²** by controlling the oxygen flow rate to **1**%.

When the flow ratio of oxygen O**₂** to nitrogen N**₂** is **0**%, a lower limit in the measurement range of the effective carrier concentration N_{D}-N_{A} is **1.28x10¹⁸** [/cm**³**] and an upper limit in the measurement range of the effective carrier concentration N_{D}-N_{A} is **1.07x10¹⁹** [/cm**³**].

Thus, if the effective carrier concentration N_{D}-N_{A} is in the range of **1.28x10¹⁸** to **1.07x10¹⁹** [/cm**³**], the average density of linear pits on the β-Ga**₂**O**₃**-based single crystal **23** can be reduced to not more than **1000** pits/cm**²** by controlling the oxygen flow rate to **0**%.

### (Effects of the embodiment)

In the present embodiment, a gallium oxide substrate having an average linear pit density of not more than **1000** pits/cm**²** can be obtained by controlling the amount of oxygen in the atmosphere gas used during growth of the β-Ga**₂**O**₃**-based single crystal **23.**

By using such gallium oxide substrate as a growth substrate, it is possible to epitaxially grow a high-quality crystal film with low linear pit density.

As a result, it is possible to increase the yield of LED device or power device, etc., formed using the gallium oxide substrate and a crystal film thereon.

Although the typical embodiment, modification and illustrated example of the invention have been described, the invention according to claims is not intended to be limited to the embodiment, modification and illustrated example, as obvious from the above description. Therefore, it should be noted that all combinations of the features described in the embodiment, modification and illustrated example are not necessary to solve the problem of the invention.

### [Industrial Applicability]

A gallium oxide substrate which has a reduced number of linear pits is provided.

### [Reference Signs List]

- **10**: EFG CRYSTAL MANUFACTURING APPARATUS
- **11**: Ga**₂**O**₃**-BASED MELT
- **12**: CRUCIBLE
- **13**: DIE
- **13**a: SLIT
- **13b**: OPENING
- **14**: LID
- **20**: β-Ga**₂**O**₃**-BASED SEED CRYSTAL
- **21**: SEED CRYSTAL HOLDER
- **22**: SHAFT
- **23**: β-Ga**₂**O**₃**-BASED SINGLE CRYSTAL

## Claims

1. A gallium oxide substrate, wherein an average value of a density of linear pits is not more than **1000** pits/cm**²** in a surface of a single crystal.

2. The gallium oxide substrate according to claim **1,** wherein an effective carrier concentration in the single crystal is in a range of **1x10¹⁷** [/cm**³**] to **1x10²⁰** [/cm**³**].

3. The gallium oxide substrate according to claim **1,** wherein an effective carrier concentration in the single crystal is in a range of **2.05x10¹⁷** [/cm**³**] to **2.23x10¹⁹** [/cm**³**].
